# EUROPEAN PATENT APPLICATION

(11) **EP 4 395 087 A1**
(43) Date of publication of application: **03.07.2024**
(21) Application number: 23218987.8
(22) Date of filing: 21.12.2023
(51) Int. Cl.: H01S 3/13, H01S 3/139, H01S 3/00, H01S 3/10, H01S 3/1106, H01S 3/23, H01S 5/065, H01S 5/068

(54) **SYNCHRONIZATION OF MODE-LOCKED LASERS**

(30) Priority: 28.12.2022 US 202263435559 P; 11.09.2023 US 202318464282
(71) Applicant: Cyber-Ridge Ltd., Tel Aviv (IL)
(72) Inventor: WOHLGEMUTH, Eyal, 56 HaHaruv Street, Moshav Haniel (IL); KELLER, Elimelech, 14 HaRav Nisim Street, Rishon Le'zion (IL); SHALOM, Hamutal, 70 Rimon Street, Yehud (IL); ATTIA, Ido, 92 Katznelson Street, Giv'atayim (IL); ALIN, Gil, 26 Hemda Street, Haifa (IL); SADOT, Dan, 143 HaDvash Street, Kfar Bilu (IL)
(74) Representative: Banse & Steglich Patentanwälte PartmbB

(57) **Abstract**

Optical apparatus (20, 50) includes a laser (31, 54), which is configured to output a first optical pulse train at a controllable pulse repetition rate (PRR). An optical coupler (30) is configured to combine the first optical pulse train with a second optical pulse train received from a reference source (28, 52) at a reference PRR. An optical detector (32) is coupled to output an electrical beat signal in response to constructive interference between the combined first and second optical pulse trains. Control circuitry (38) is configured to adjust the PRR of the laser responsively to the electrical beat signal.

## Description

### FIELD

The present invention relates generally to optoelectronic devices and systems, and particularly to control of pulsed lasers.

### BACKGROUND

A number of techniques are known in the art for generating short pulses of laser radiation at high pulse repetition rates. Mode locking of a laser, for example, can be used to produce very short pulses, with durations on the order of picoseconds or less and pulse repetition rates of many gigahertz. Mode-locking is achieved by aligning the phases of the longitudinal optical modes within the laser cavity. This sort of alignment can be achieved, for example, using a passive nonlinear element, such as a saturable absorber, in the laser cavity, or using an active modulator, such as an electro-optic or acoustooptic modulator, in the laser cavity.

In some applications of mode-locked lasers, the pulse repetition rate (and possibly the phase, as well) of the laser is synchronized to an external timing source. A variety of methods for implementing this sort of synchronization are known in the art. For example, Schlager et al. describe a method for synchronizing a passively mode-locked erbium/ytterbium codoped planar waveguide laser in "Passively mode-locked waveguide laser with low residual jitter," IEEE Photonics Technology Letters, vol. 14, no. 9, pages 1351-1353 (Sept. 2002). The authors used a piezoelectric transducer (PZT) with a phase-error detection circuit to control the laser cavity length.

As another example, Merghem et al. describe a method for stabilizing the repetition frequency of an InAs/InP quantum-dash-based mode-locked in "Long-Term Frequency Stabilization of 10-GHz Quantum-Dash Passively Mode-Locked Lasers," IEEE Journal of Selected Topics in Quantum Electronics, vol. 21, no. 6, pages 1-7 (Nov-Dec 2015). The authors developed a stabilization scheme based on an electrical feedback loop to compensate RF drift by changing the gain current applied to a section of the laser.

As yet another example, Zhou et al. describe the use of a radio-frequency (RF) signal in controlling the frequency of a gain-switched Fabry-Perot laser diode in "40nm wavelength tunable gain-switched optical comb source," Optics Express, vol. 19, pages B415-B420 (2011).

The above description of background publications is intended only as a general overview of pulsed laser technologies and techniques that can be used to control such lasers. It should not be construed as an admission that any aspect of the above publications constitutes prior art against the inventions that are described and claimed hereinbelow.

The terms "light" and "optical radiation" are used in the present description and the claims to refer to electromagnetic radiation in any of the visible, infrared, and ultraviolet spectral ranges.

### SUMMARY

Embodiments of the present invention that are described hereinbelow provide improved circuits and techniques for controlling pulsed lasers, as well as devices and systems implementing such techniques.

There is therefore provided, in accordance with an embodiment of the invention, optical apparatus, including a laser, which is configured to output a first optical pulse train at a controllable pulse repetition rate (PRR). An optical coupler is configured to combine the first optical pulse train with a second optical pulse train received from a reference source (which may be a different laser or the same laser) at a reference PRR. An optical detector is coupled to output an electrical beat signal in response to constructive interference between the combined first and second optical pulse trains. Control circuitry is configured to adjust the PRR of the laser responsively to the electrical beat signal. When two lasers are used, the PRRs of both the lasers may be adjusted.

In a disclosed embodiment, the laser is mode-locked.

In some embodiments, the apparatus includes an intradyne coherent receiver, which includes the optical coupler and the optical detector. In some of these embodiments, the intradyne coherent receiver is coupled to receive a pulsed optical information signal over an optical communication link and to extract data from the pulsed optical information signal by mixing the pulsed optical information signal with the first optical pulse train. In a disclosed embodiment, the laser generating the first optical pulse train is a local laser, and a remote laser both serves as the reference source and generates the pulsed optical information signal, and the control circuitry is configured to synchronize the PRR of the local laser with the remote laser. The control circuitry may be configured to synchronize the PRR of the local laser with the remote laser under conditions of negative optical signal/noise ratio on the optical communication link.

Additionally or alternatively, the laser generating the first optical pulse train is a first laser, and the reference source includes a second laser, and the control circuitry is configured to synchronize the PRR of the second laser with the first laser.

In a disclosed embodiment, the optical mixer includes an optical hybrid, which is configured to generate in-phase (I) and quadrature (Q) outputs, and the optical detector is configured to sense both the I and Q outputs. Additionally or alternatively, the optical mixer includes at least a first mixer coupled to receive a first polarization of the first and second optical pulse trains and a second mixer coupled to receive a second polarization of the first and second optical pulse trains, and the optical detector is configured to output the electrical beat signal in response to the constructive interference in both the first and second polarizations. In a disclosed embodiment, the control circuitry is configured to sense and possibly to adjust a polarization of the laser responsively to the electrical beat signal.

In some embodiments, the control circuitry is configured to drive the PRR of the laser, based on the electrical beat signal, to maximize a temporal overlap between the first and second optical pulse trains. In a disclosed embodiment, the control circuitry includes a peak detector, which is configured to detect the overlap between the first and second optical pulse trains. Alternatively, the control circuitry is configured to detect an average envelope of the electrical beat signal as an indicator of the overlap between the first and second optical pulse trains.

In another embodiment, the control circuitry is configured to adjust a pulse amplitude of the laser responsively to the electrical beat signal. Additionally or alternatively, the control circuitry is configured to adjust a pulse timing phase of the first optical pulse train responsively to the electrical beat signal.

In a further embodiment, the laser serves as the reference source, and the first and second pulse trains are input from the laser to the optical mixer via different, first and second optical paths, and the control circuitry measures an autocorrelation of the pulse trains.

Alternatively, the control circuitry is configured to measure a pulse shape of the first optical pulse train by sensing an amplitude variation of the electrical beat signal while shifting a pulse-timing phase of the first optical pulse train relative to the second optical pulse train, thereby measuring a cross-correlation between the first and second pulse trains.

There is also provided, in accordance with an embodiment of the invention, a method for controlling a laser, which outputs a first optical pulse train at a controllable pulse repetition rate (PRR). The method includes optically mixing the first optical pulse train with a second optical pulse train received from a reference source at a reference PRR, thereby generating an optical beat signal in response to constructive interference between the first and second optical pulse trains. The PRR of the laser is adjusted responsively to the optical beat signal.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a laser communication system, in accordance with an embodiment of the invention;
Fig. 2 is a schematic circuit diagram illustrating elements of a receiver used in the system of Fig. 1;
Fig. 3 is a block diagram that schematically illustrates a system for synchronizing pulsed laser outputs, in accordance with an embodiment of the invention; and
Figs. 4A and 4B are plots that schematically illustrate control signals used in synchronizing a pair of pulsed lasers, before and after synchronization, respectively, in accordance with an embodiment of the invention.

### DETAILED DESCRIPTION

### OVERVIEW

Mode-locked lasers are generally capable of generating high-speed optical pulse trains, and passively mode-locked lasers emit such pulse trains without external timing control. In some applications, however, it is beneficial to synchronize the pulse train outputs of two or more mode-locked lasers. For example, in coherent pulsed optical communications, the pulse repetition rate (PRR) of the mode-locked laser that is used to generate the local oscillator beam for signal demodulation in the receiver should be synchronized with the PRR of the mode-locked laser that was used to generate the modulated pulse train in the transmitter. Other applications that call for synchronizing multiple mode-locked lasers include optical sensing, as well as high-precision clock generation and distribution. Existing methods for synchronizing mode-locked lasers, however, are complex and costly, with the complexity and cost increasing as the PRR grows and the temporal pulse shape narrows.

Embodiments of the present invention that are described herein address these problems using a simple, inexpensive coherent optical mixing and detection circuit, of the type that is used in coherent optical communication receivers. This optical circuit receives as inputs the optical pulse trains generated by a pair of lasers that are to be synchronized and outputs a beat signal due to constructive interference between the pulses in the trains. The average peak amplitude or envelope of this beat signal increases as the pulse trains are synchronized and thus can be used as a feedback control input to adjust the PRR of one or both of the lasers.

While this scheme can be used in synchronizing laser pulses less than a picosecond in duration, with PRR in the gigahertz range, it requires only low-speed, inexpensive electronic components, such as balanced photodiode pairs to detect the average envelope of the optical beat signal and a transimpedance amplifier (TIA) to amplify the electrical beat signal output by each photodiode pair. In fact, these components, together with the optical mixer that mixes the pulse trains that are to be synchronized, are already used for coherent intradyne demodulation in existing optical receivers. These existing components can be adapted, for example, for synchronization of the laser that is used to generate the pulsed local oscillator beam at only minimal additional cost. The use of coherent detection makes it possible to synchronize the lasers precisely even in the presence of high optical channel noise, including conditions of negative optical signal/noise ratio (in logarithmic terms), in which the amplitude of the noise is greater than that of the signal.

Alternatively, although the embodiments described below relate specifically to optical communications, the principles of these embodiments may be applied in synchronizing pulsed lasers for other applications. The techniques and circuits that are described herein may be used not only in controlling the laser PRR, but also in synchronizing the pulse-timing phases, amplitudes, and/or polarizations of the optical pulse trains output by the lasers. Additionally or alternatively, these optical and electronic circuits may be adapted for measuring pulse shapes in high-speed optical pulse trains by sensing the amplitude variation of the electrical beat signal while shifting the pulse timing phase of one of the optical pulse trains relative to the other, i.e., measuring the auto-correlation or cross-correlation between the pulses.

In some embodiments, to generate the auto-correlation, the laser output is split, and one branch is temporally shifted relative to the second branch, for instance, using an optical delay line (ODL). Alternatively, a cross-correlation between two pulse trains from two lasers is generated by allowing both lasers to operate in a free-running mode. The resulting PRR difference generates the required variations. As noted above, all these functionalities can be implemented using inexpensive electronic components, with bandwidths much narrower than that of the optical pulse trains to which they are applied.

Although the embodiments that are described hereinbelow relate specifically to mode-locked lasers, the principles of the present invention may alternatively be applied in synchronizing other types of high-speed pulsed lasers to generate pulse trains having identical repetition rates.

Thus, the embodiments described herein provide optical apparatus and methods in which a laser outputs an optical pulse train at a controllable PRR. An optical coupler combines this optical pulse train with a reference optical pulse train, received from a reference source at a reference PRR. (The reference source may be local or remote, for example at the far end of an optical communication channel.) An optical detector receives the combined optical signal from the optical coupler, thus mixing the optical signals, and outputs an electrical beat signal in response to constructive interference between the combined optical pulse trains. Control circuitry adjusts the PRR of the laser, and possibly other parameters, as well, in response to the electrical beat signal.

The disclosed embodiments obviate the need for an optical phase-locked loop OPLL to synchronize the lasers. In the absence of such an OPLL, there will be a carrier-envelope offset (CEO) frequency difference between the two lasers that are to be synchronized. The CEO frequency difference gives rise to a beat signal, oscillating at rates in the megahertz range, and a peak detector can extract meaningful information from such beating.

### SYSTEM DESCRIPTION

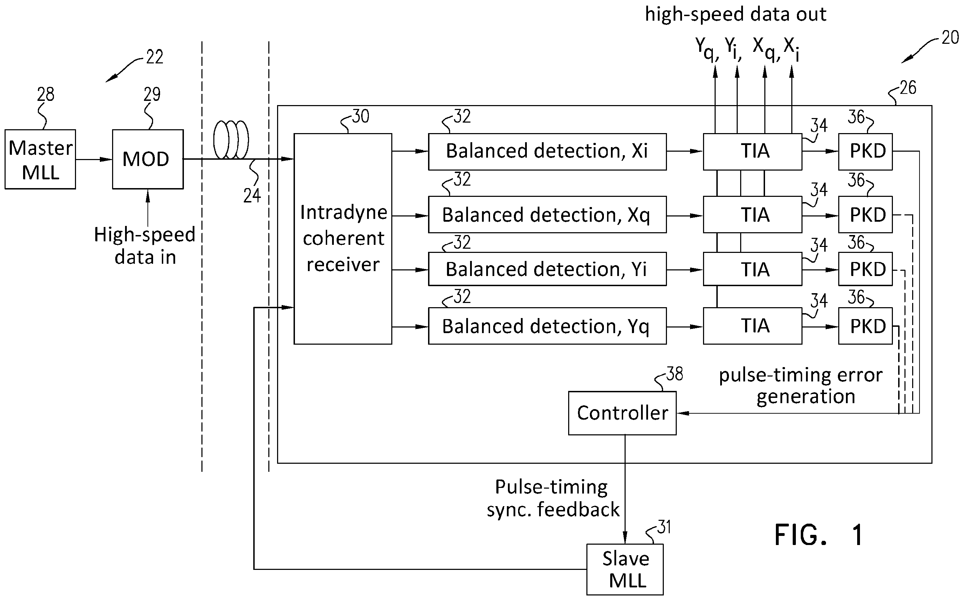

Fig. 1 is a block diagram that schematically illustrates a laser communication system 20, in accordance with an embodiment of the invention. In system 20, a transmitter 22 transmits a pulsed optical signal over a communication link 24 to a receiver 26. Transmitter 22 comprises a mode-locked laser (MLL) 28, which generates a high-speed optical pulse train, and a modulator 29, which modulates the optical pulse train to carry a stream of high-speed data over link 24. Although link 24 is represented in the pictured embodiment as an optical fiber, the principles of this embodiment may alternatively be implemented over any suitable sort of optical communication link, such as a free-space optical link.

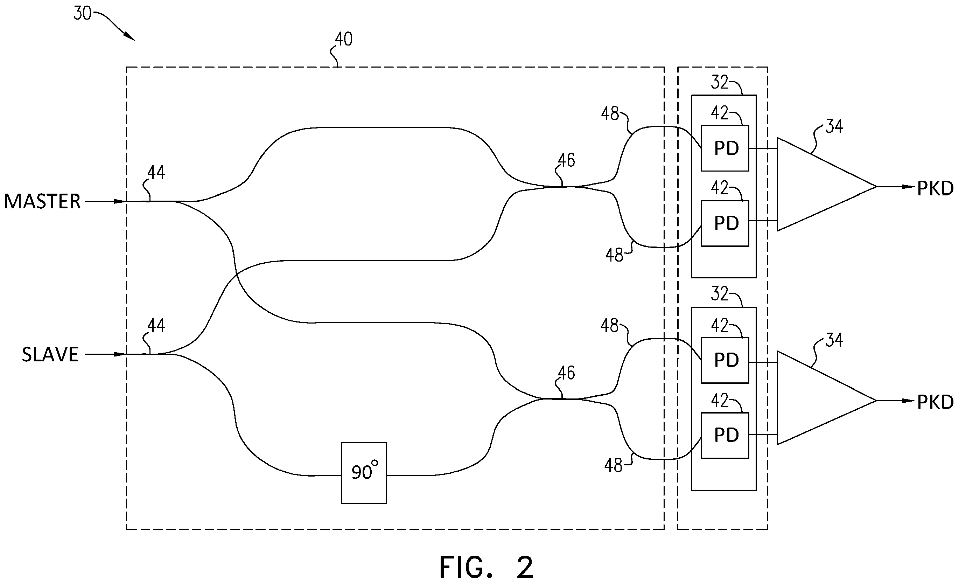

Receiver 26 comprises an intradyne coherent optical receiver 30, which mixes the pulsed optical information signal received from optical communication link 24 with a local oscillator beam comprising an optical pulse train generated by a local mode-locked laser (MLL) 31. Details of a mixer that can be used in intradyne coherent optical receiver 30 are shown in Fig. 2. Laser 28 is identified in Fig. 1 as the "Master MLL," while laser 31 is identified as the "Slave MLL," because control circuitry synchronizes the PRR of the optical pulse train generated by laser 31 with a reference PRR derived from the optical pulse train generated by laser 28, as described further hereinbelow. Laser 28 is also referred to in this context as the remote beam source, while laser 31 is the local beam source. Lasers 28 and 31 in this example comprise semiconductor lasers containing saturable absorbers for purposes of passive mode locking; but alternatively other types of mode-locked lasers may be used in system 20, with either passive or active mode locking. For example, the principles of the present embodiments may be applied in synchronizing the PRR of the various types of mode-locked lasers that are described above in the Background section.

In the present example, intradyne coherent optical receiver 30 comprises at least two optical mixers, for example of the type shown below in Fig. 2. The mixers are preceded by a polarization beamsplitter (not shown) so that one mixer receives one polarization component of the remote and local optical pulse trains, for example the X-polarized component, while the other mixer receives the orthogonal polarization component, from example the Y-polarized component. Thus, the two mixers generate optical beat signals due to constructive interference between the respective polarization components of the remote and local optical pulse trains. Furthermore, each of the optical mixers comprises an optical hybrid, which generates in-phase (I) and quadrature (Q) outputs representing the I and Q phase components of the optical beat signal.

Balanced photodiode pairs 32 serve as optical detectors to receive and sense the optical beat signals generated by each of the mixers in receiver 30: the I and Q components of the X-polarization mixed signal (Xᵢ and X_{q}) and the I and Q components of the Y-polarization mixed signal (Yᵢ and Y_{q}). The signals output by the photodiodes in each pair 32 are subtracted and amplified by respective trans-impedance amplifiers (TIAs) 34. In normal operation, these amplified signals are digitized and demodulated to extract the high-speed data that was sent by transmitter 22.

For the purpose of synchronizing local MLL 31 with remote MLL 28, control circuitry in receiver 26 uses the electrical beat signals that are output by one or more of TIAs 34 in adjusting the pulse timing of MLL 31. The purpose of this adjustment is to maximize the overlap between the pulses received from the two lasers, which will be expressed by a consistently high amplitude of the electrical beat signal. In the present embodiment, for this purpose, the control circuitry in receiver 26 comprises peak detectors 36, which detect the peak values of the electrical beats output by TIAs 34. Alternatively, other sorts of electrical detection circuits may be used to track the amplitude of the electrical beat signal, for example envelope detectors (not shown).

The control circuitry in receiver 26 comprises a controller 38, which senses the output level of peak detectors 36 and drives laser 31 accordingly to maximize the output level. In other words, controller 38 senses any deviation from the maximum peak detector output level (either passively or possibly by dithering a setting of laser 31) and generates a feedback signal to adjust the laser pulse parameters. Controller 38 typically comprises logic circuits with suitable interfaces and converters (analog/digital and digital/analog) to perform the measurement and control functions that are described here. The logic circuits may be hard-wired or programmable. Alternatively or additionally, controller 38 may comprise analog control circuits. Further alternatively or additionally, at least some of the logical functions of controller 38 may be performed by a programmable microcontroller and/or by a field-programmable gate array (FPGA) and/or by an application-specific integrated circuit (ASIC).

The type of feedback signal that controller 38 applies to laser 31 depends on the characteristics of the laser itself. For example, when laser 31 is passively mode-locked, controller 38 may adjust the PRR of the laser by modifying the length of the laser cavity (for instance using a piezoelectric element). Alternatively or additionally, controller 38 may adjust the PRR by increasing or decreasing the drive current that is applied to laser 31 or by controlling a saturable absorber or other element in the laser cavity. As another example, when laser 31 is actively mode-locked using an intracavity modulator, controller 38 may adjust the PRR by modifying the signal that is applied to the modulator.

To synchronize the PRR of laser 31 with the incoming reference signal from laser 28, a single peak detector 36 (or other amplitude detector) would be sufficient. Using multiple detectors, however, as shown in Fig. 1 is advantageous in enriching the available synchronization information to include differential phase (I/Q) and polarization (X/Y) inputs. Controller 38 can use the I/Q inputs, for example, in adjusting the phase of the pulse train output by laser 31 by applying small, transient variations to the PRR and/or by controlling a variable optical delay line (not shown). Additionally or alternatively, controller 38 can use the inputs to measure parameters such as the differential group delay (DGD) and polarization splitting ratio and thus provide feedback to adjust the polarization of laser 31. Additionally or alternatively, controller 38 may adjust the pulse amplitude of laser 31, for example by adjusting the drive current applied to the laser, based on the amplitude of the electrical beat signal that is sensed by peak detectors 36.

Fig. 2 is a schematic circuit diagram illustrating elements of receiver 30 and balanced photodiode pairs 32 in receiver 26 (Fig. 1), in accordance with an embodiment of the invention. Receiver 30 comprises an optical hybrid 40, which is based on a network of optical waveguides disposed on a substrate. Optical hybrid 40 has two inputs 44 for receiving the reference (master) and local (slave) pulse trains from lasers 28 and 31, respectively, and two couplers 46, one of which combines the master and slave pulse trains in their original phases, while the other combines the pulse trains with a 90° relative phase shift. The combined pulse trains are coupled via outputs 48 to balanced pairs 32 of photodiodes 42, which detect the optical beat signals generated due to mixing of the optical inputs. The photodiode outputs are coupled as differential inputs to TIAs 34.

To generate trains of sub-picosecond pulses, lasers 28 and 31 typically have large spectral bandwidths. Couplers 46 will generate appreciable optical beat signals as long as there is sufficient overlap between the respective spectral bands of the lasers. The respective center wavelengths of lasers 28 and 31 need not be locked together and may differ substantially from one another as long as this overlap condition is satisfied.

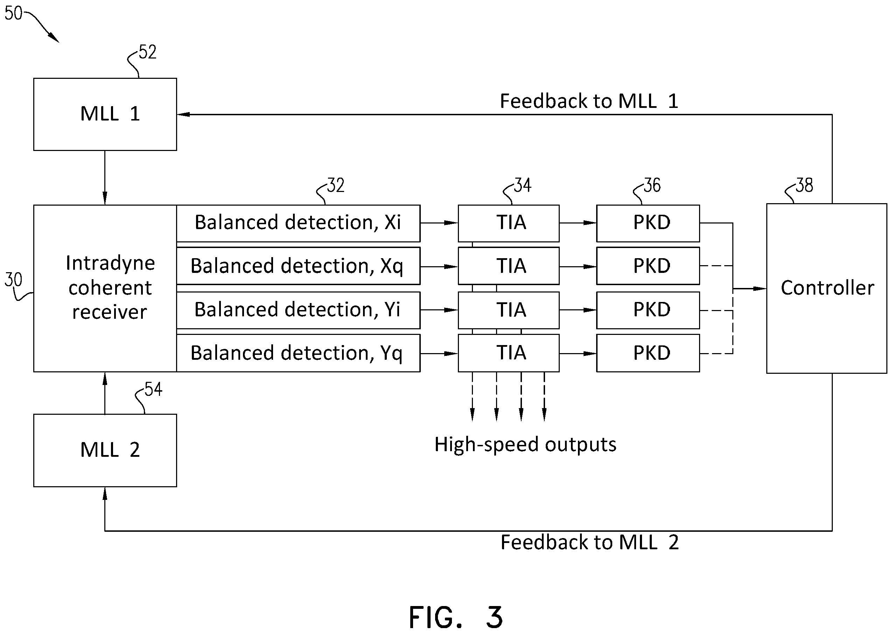

Fig. 3 is a block diagram that schematically illustrates a system 50 for synchronizing the outputs of two pulsed lasers 52 and 54 (labeled MLL 1 and MLL 2), in accordance with an embodiment of the invention. The principles of operation of system 50, in terms of coherent detection of the overlap between two laser pulse trains, are similar to those applied in system 20 (Fig. 1), and the components of system 50 are labeled with the same indicator numbers as the corresponding components of system 20. Because lasers 52 and 54 in system 50 are collocated, however, controller 38 can use the electrical beat signals that are generated by this system in providing feedback control signals to both of the lasers.

As a further alternative, coherent receiver 30 in system 50 can be used in a homodyne mode to synchronize two pulse trains that are output by the same laser. For example, one of the pulse trains may be a beam of pulses that is transmitted from system 50 over a given optical path, while the other pulse train is a local oscillator beam that is split off to a different optical path.

In this sort of homodyne configuration, system 50 can also be used to measure the pulse width and pulse shape of the optical pulses generated by a given laser, without requiring high-speed detectors or electronics, by means of measuring the auto-correlation function. For this purpose, controller 38 senses the average amplitude variation of the electrical beat signal as the phase of one of the optical pulse trains is shifted relative to the other. The average amplitude variation represents the autocorrelation of the pulse shape function and can be processed simply to recover the actual pulse shape. The cross-correlation between pulses from two different sources can be measured in similar fashion.

### EXPERIMENTAL DEMONSTRATION

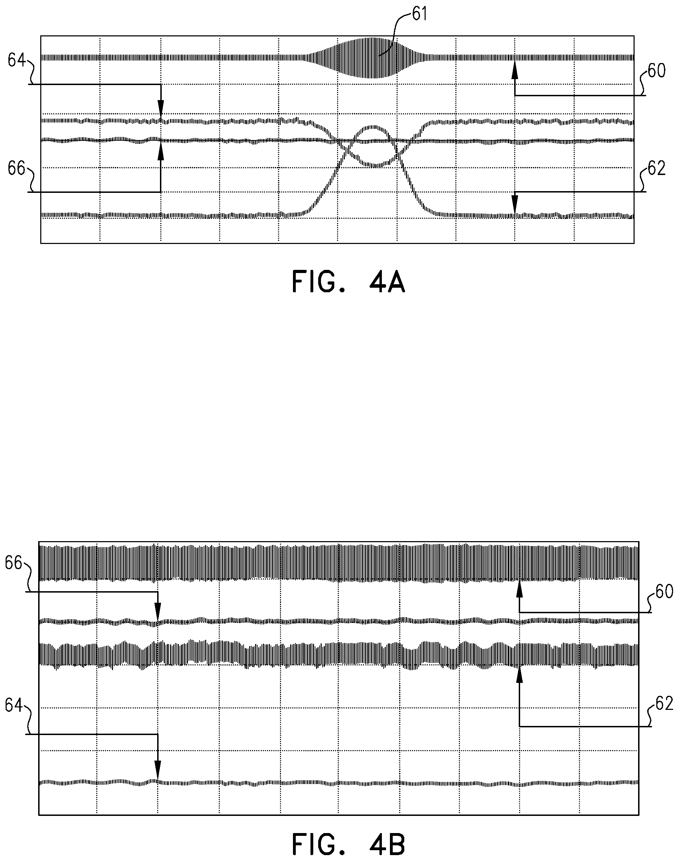

Figs. 4A and 4B are plots that schematically illustrate control signals used in synchronizing lasers 52 and 54 in system 50 (Fig. 3), before and after synchronization, respectively, in accordance with an embodiment of the invention.

In Fig. 4A, lasers 52 and 54 operate in a free-running mode, at different, respective PRRs, without synchronization. A curve 60 represents the high-speed output of one of TIAs 34, which is zero except when the pulses in the two pulse trains happen to overlap, as illustrated by a bulge 61 in the signal amplitude. A curve 62 illustrates the corresponding output of peak detector 36, which traces the envelope of curve 60. Controller 38 generates an error signal, represented by a curve 64, which is proportional to the difference between a reference setpoint value and curve 62. At this stage, the feedback loops from controller 38 to lasers 52 and 54 are deactivated, and the feedback signal to laser 54, represented by a curve 66, is simply constant over time.

In Fig. 4B, laser 52 is locked to a reference crystal frequency, and controller 38 synchronizes laser 54 with laser 52 using the signals output by peak detectors 36. Curve 60 in this case shows a high-amplitude, continuous beat signal, and curve 62 accordingly shows a stable, continuous peak amplitude. The level of the error signal represented by curve 64 is low, while the feedback signal represented by curve 66 is strong and stable.

The embodiments described above are cited by way of example, and the present invention is not limited to what has been particularly shown and described hereinabove. Rather, the scope of the present invention includes both combinations and subcombinations of the various features described hereinabove, as well as variations and modifications thereof which would occur to persons skilled in the art upon reading the foregoing description and which are not disclosed in the prior art.

## Claims

1. Optical apparatus (20, 50), comprising:
a laser (31, 54), which is configured to output a first optical pulse train at a controllable pulse repetition rate (PRR);
an optical coupler (30), which is configured to combine the first optical pulse train with a second optical pulse train received from a reference source (28, 52) at a reference PRR;
an optical detector (32) coupled to output an electrical beat signal in response to constructive interference between the combined first and second optical pulse trains; and
control circuitry (38) configured to adjust the PRR of the laser responsively to the electrical beat signal.

2. The apparatus according to claim 1, wherein the laser is mode-locked.

3. The apparatus according to claim 1 or 2, and comprising an intradyne coherent receiver, which comprises the optical coupler and the optical detector.

4. The apparatus according to claim 3, wherein the intradyne coherent receiver is coupled to receive a pulsed optical information signal over an optical communication link and to extract data from the pulsed optical information signal by mixing the pulsed optical information signal with the first optical pulse train.

5. The apparatus according to claim 4, wherein the laser generating the first optical pulse train is a local laser, and the reference source comprises a remote laser, which generates the pulsed optical information signal, and
wherein the control circuitry is configured to synchronize the PRR of the local laser with the remote laser.

6. The apparatus according to claim 5, wherein the control circuitry is configured to synchronize the PRR of the local laser with the remote laser under conditions of negative optical signal/noise ratio on the optical communication link.

7. The apparatus according to claim 3, wherein the laser generating the first optical pulse train is a first laser, and the reference source comprises a second laser, and
wherein the control circuitry is configured to synchronize the PRR of the second laser with the first laser.

8. The apparatus according to any of claims 1-7, wherein the optical mixer comprises an optical hybrid, which is configured to generate in-phase (I) and quadrature (Q) outputs, and
wherein the optical detector is configured to sense both the I and Q outputs.

9. The apparatus according to any of claims 1-8, wherein the optical mixer comprises at least a first mixer coupled to receive a first polarization of the first and second optical pulse trains and a second mixer coupled to receive a second polarization of the first and second optical pulse trains, and
wherein the optical detector is configured to output the electrical beat signal in response to the constructive interference in both the first and second polarizations.

10. The apparatus according to claim 9, wherein the control circuitry is configured to adjust a polarization of the laser responsively to the electrical beat signal.

11. The apparatus according to any of claims 1-10, wherein the control circuitry is configured to drive the PRR of the laser, based on the electrical beat signal, to maximize an overlap between the first and second optical pulse trains.

12. The apparatus according to claim 11, wherein the control circuitry comprises a peak detector, which is configured to detect the overlap between the first and second optical pulse trains.

13. The apparatus according to any of claims 1-12, wherein the control circuitry is configured to measure a pulse shape of the first optical pulse train by sensing an amplitude variation of the electrical beat signal while a phase of the first optical pulse train shifts relative to the second optical pulse train, thereby measuring a cross-correlation between the first and second pulse trains.

14. The apparatus according to any of claims 1-13, wherein the control circuitry is configured to measure a carrier-envelope offset (CEO) frequency difference between the first and second optical pulse trains.

15. A method for controlling a laser (31, 54), which outputs a first optical pulse train at a controllable pulse repetition rate (PRR), the method comprising:
optically mixing the first optical pulse train with a second optical pulse train received from a reference source (28, 52) at a reference PRR, thereby generating an optical beat signal in response to constructive interference between the first and second optical pulse trains; and
adjusting the PRR of the laser responsively to the optical beat signal.
